(19) Europäisches Patentamt / European Patent Office / Office européen des brevets

(11) **EP 4 657 729 A1**

(12) **EUROPEAN PATENT APPLICATION**
published in accordance with Art. 153(4) EPC

(43) Date of publication:
03.12.2025 Bulletin 2025/49

(21) Application number: 24890226.4

(22) Date of filing: 13.08.2024

(51) International Patent Classification (IPC):
*H02M 1/00* (2006.01)   *H02P 21/00* (2016.01)

(52) Cooperative Patent Classification (CPC):
G01R 19/25; G01R 31/34; H02M 1/00; H02P 6/28;
H02P 21/00; H02P 25/022; H02P 27/08

(86) International application number:
PCT/CN2024/111797

(87) International publication number:
WO 2025/102863 (22.05.2025 Gazette 2025/21)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 13.11.2023 CN 202311526796

(71) Applicants:
• Anqing Welling Auto Parts Co., Ltd.
Anqing, Anhui 246008 (CN)

• Anhui Welling Auto Parts Corporation Limited
Hefei, Anhui 230088 (CN)
• Guangdong Welling Auto Parts Corporation
Limited
Foshan, Guangdong 528311 (CN)

(72) Inventor: SONG, Wanjie
Anqing, Anhui 246008 (CN)

(74) Representative: Ran, Handong et al
Maucher Jenkins
Seventh Floor Offices
Artillery House
11-19 Artillery Row
London SW1P 1RT (GB)

(54) **FREQUENCY CONVERTER AND CURRENT SAMPLING CIRCUIT THEREOF, AND THREE-PHASE CURRENT SAMPLING METHOD FOR MOTOR**

(57)     A frequency converter and a current sampling circuit thereof, and a three-phase current sampling method for a motor. The frequency converter (1000) is suitable for driving a motor (M) in a compressor. The current sampling circuit comprises: a single-resistor sampling unit (10) configured to perform current sampling at a voltage effective vector moment to obtain three-phase currents of the motor (M); a multi-resistor sampling unit (20) configured to perform current sampling at a voltage zero vector moment to obtain three-phase currents of the motor (M); and a switching control unit (30) configured to acquire a parameter of the motor (M), determine a switching index on the basis of the parameter of the motor (M), and select one of the single-resistor sampling unit (10) and the multi-resistor sampling unit (20) on the basis of the switching index to perform current sampling.

FIG. 1

**Description**

**CROSS-REFERENCE TO RELATED APPLICATION**

This application claims priority to Chinese patent application No. 202311526796.X, titled "FREQUENCY CONVERTER AND CURRENT SAMPLING CIRCUIT THEREOF, AND THREE-PHASE CURRENT SAMPLING METHOD FOR MOTOR" and filed on November 13, 2023, the entire contents of which are incorporated herein by reference.

**FIELD**

The invention relates to the field of motor control technologies, and particularly, to a frequency converter and a current sampling circuit thereof, and a three-phase current sampling method for a motor.

**BACKGROUND**

A permanent magnet synchronous motor, which offers advantages such as high efficiency, high power density, and simple structure, is widely applied in fields of industry, household appliances, automobiles, etc. Current sampling is the key to motor control. Commonly used current sampling methods include current sensor sampling, resistor sampling, and the like. The resistor sampling is widely used in cost-sensitive applications due to its low-cost advantage. Available resistor sampling schemes include single-resistor sampling, dual-resistor sampling, triple-resistor sampling, etc.

A principle of the dual-resistor sampling is similar to that of the triple-resistor sampling. A sampling resistor is located at a lower bridge of an inverter, and is configured to perform current sampling at a voltage zero vector moment. Therefore, a modulation ratio cannot be too high, requiring that a time length of a voltage zero vector is longer than a minimum sampling time length of the current sampling. As a result, the dual-resistor sampling suffers from relatively low voltage utilization in high-speed applications. In the single-resistor sampling, a sampling resistor is located at a direct current bus, and is configured to perform current sampling at a voltage effective vector moment. However, in the low speed and sector transition regions, a time length of a voltage effective vector is shorter than the minimum sampling time length of the current sampling. Typically, a method of Pulse Width Modulation (PWM) phase shifting is adopted to ensure a sufficient voltage effective vector time length for current sampling, but the PWM phase shifting introduces a current distortion and consequently results in loud motor noises.

**SUMMARY**

The invention aims to solve at least one of the technical problems in the related art to some extent. To this end, a first objective of the invention is to provide a current sampling circuit of a frequency converter, capable of switching between single-resistor sampling and multi-resistor sampling based on a parameter of a motor. In this way, the invention solves problems of loud motor noises caused by using only single-resistor sampling and degraded motor performance caused by using only multi-resistor sampling, improving performance of the motor.

A second objective of the invention is to provide a frequency converter.

A third objective of the invention is to provide a three-phase current sampling method for a motor.

A fourth objective of the invention is to provide a computer-readable storage medium.

A fifth objective of the invention is to provide another frequency converter.

A sixth objective of the invention is to provide a compressor.

A seventh objective of the invention is to provide a vehicle.

To achieve the above objectives, according to embodiments in a first aspect of the invention, a current sampling circuit of a frequency converter is provided. The frequency converter is adapted to drive a motor in a compressor. The current sampling circuit includes: a single-resistor sampling unit configured to perform current sampling at a voltage effective vector moment to obtain a three-phase current of the motor; a multi-resistor sampling unit configured to perform current sampling at a voltage zero vector moment to obtain the three-phase current of the motor; and a switching control unit configured to acquire a parameter of the motor, determine a switching index based on the parameter of the motor, and select, based on the switching index, one of the single-resistor sampling unit and the multi-resistor sampling unit to perform current sampling.

The current sampling circuit of the frequency converter according to the embodiments of the invention includes the single-resistor sampling unit, the multi-resistor sampling unit, and the switching control unit. The switching control unit is configured to acquire the parameter of the motor, determine the switching index based on the parameter of the motor, and select, based on the switching index, one of the single-resistor sampling unit and the multi-resistor sampling unit to perform current sampling. In this way, the switching control unit is capable of switching between single-resistor sampling and multi-resistor sampling based on the parameter of the motor and respective application scenarios of the single-resistor sampling and the multi-resistor sampling, which solves the problems of loud motor noises caused by using only single-resistor sampling and degraded motor performance caused by using only multi-resistor sampling. As a result, a speed adjustment range of the motor is extended, improving the performance of the motor.

According to an embodiment of the invention, the parameter of the motor includes a voltage operation range and a maximum torque of the motor, and the switching control unit is further configured to determine a switching rotational speed based on the voltage operation range and the maximum torque.

According to an embodiment of the invention, the switching control unit is further configured to: determine, in response to the motor operating at a lower limit of the voltage operation range and the maximum torque, a maximum rotational speed at which the motor does not enter field-weakening control; and determine the switching rotational speed based on the maximum rotational speed.

According to an embodiment of the invention, the switching control unit is further configured to: acquire a current rotational speed of the motor; and in response to the current rotational speed being greater than the switching rotational speed, select the single-resistor sampling unit to perform current sampling, or in response to the current rotational speed being smaller than or equal to the switching rotational speed, select the multi-resistor sampling unit to perform current sampling.

According to an embodiment of the invention, the parameter of the motor includes a modulation period and a minimum current sampling time length of the motor, and the switching control unit is further configured to determine a switching modulation ratio based on the modulation period and the minimum current sampling time length.

According to an embodiment of the invention, the switching control unit is further configured to: calculate a difference between the modulation period and four times the minimum current sampling time length; divide the difference by the modulation period to obtain a maximum modulation ratio; and determine the switching modulation ratio based on the maximum modulation ratio.

According to an embodiment of the invention, the switching control unit is further configured to: acquire a current modulation ratio of the motor; and in response to the current modulation ratio being greater than the switching modulation ratio, select the single-resistor sampling unit to perform current sampling, or in response to the current modulation ratio being smaller than or equal to the switching modulation ratio, select the multi-resistor sampling unit to perform current sampling.

To achieve the above objectives, according to embodiments in a second aspect of the invention, a frequency converter is provided. The frequency converter includes the current sampling circuit according to any of the above embodiments.

With the frequency converter according to the embodiments of the invention, the above current sampling circuit is adopted, and switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

To achieve the above objectives, according to embodiments in a third aspect of the invention, a three-phase current sampling method for a motor is provided. The motor is disposed in a compressor. The three-phase current sampling method is applied in a frequency converter. The frequency converter is adapted to drive the motor and includes a single-resistor sampling unit and a multi-resistor sampling unit. The three-phase current sampling method includes: acquiring a parameter of the motor, and determining a switching index based on the parameter of the motor; and selecting, based on the switching index, one of the single-resistor sampling unit and the multi-resistor sampling unit to perform current sampling, to obtain a three-phase current of the motor.

With the three-phase current sampling method for the motor according to the embodiments of the invention, the parameter of the motor is acquired, and the switching index is determined based on the parameter of the motor; and one of the single-resistor sampling unit and the multi-resistor sampling unit is selected based on the switching index to perform current sampling. The frequency converter includes the single-resistor sampling unit, the multi-resistor sampling unit, and a switching control unit. In this way, switching is performed between the single-resistor sampling and the multi-resistor sampling based on the parameter of the motor and respective application scenarios of the single-resistor sampling and the multi-resistor sampling, which solves the problems of loud motor noises caused by using only single-resistor sampling and degraded motor performance caused by using only multi-resistor sampling. As a result, the speed adjustment range of the motor is extended, improving the performance of the motor.

According to an embodiment of the invention, the parameter of the motor includes a voltage operation range and a maximum torque of the motor, and the determining the switching index based on the parameter of the motor includes: determining, in response to the motor operating at a lower limit of the voltage operation range and the maximum torque, a maximum rotational speed at which the motor does not enter field-weakening control; and determining a switching rotational speed based on the maximum rotational speed.

According to an embodiment of the invention, the selecting, based on the switching index, one of the single-resistor sampling unit and the multi-resistor sampling unit to perform current sampling includes: acquiring a current rotational speed of the motor; and in response to the current rotational speed being greater than the switching rotational speed, selecting the single-resistor sampling unit to perform current sampling, or in response to the current rotational speed being smaller than or equal to the switching rotational speed, selecting the multi-resistor sampling unit to perform current sampling.

According to an embodiment of the invention, the parameter of the motor includes a modulation period and a minimum current sampling time length of the motor, and the determining the switching index based on the parameter of the motor includes: calculating a difference between the modulation period and four times the minimum current sampling time length; dividing the difference by the modulation period to obtain a maximum modulation ratio; and determining a switching modulation ratio based on the maximum modulation ratio.

According to an embodiment of the invention, the selecting, based on the switching index, one of the single-resistor sampling unit and the multi-resistor sampling unit to perform current sampling includes: acquiring a current modulation ratio of the motor; and in response to the current modulation ratio being greater than the switching modulation ratio, selecting the single-resistor sampling unit to perform current sampling, or in response to the current modulation ratio being smaller than or equal to the switching modulation ratio, selecting the multi-resistor sampling unit to perform current sampling.

To achieve the above objectives, according to embodiments in a fourth aspect of the invention, a computer-readable storage medium is provided. The computer-readable storage medium stores a three-phase current sampling program for a motor. The three-phase current sampling program, in response to being executed by a processor, implements the three-phase current sampling method for the motor according to any of the above embodiments.

With the computer-readable storage medium according to the embodiments of the invention, the above three-phase current sampling method for the motor is performed by the three-phase current sampling program, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

To achieve the above objectives, according to embodiments in a fifth aspect of the invention, another frequency converter is provided. The frequency converter includes: a memory; a processor; and a three-phase current sampling program for a motor stored on the memory and executable on the processor. The processor, in response to being executing the three-phase current sampling program, implements the three-phase current sampling method for the motor according to any of the above embodiments.

With the frequency converter according to the embodiments of the invention, the three-phase current sampling program implementing the above three-phase current sampling method for the motor is executed by the processor, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

To achieve the above objectives, according to embodiments in a sixth aspect of the invention, a compressor is provided. The compressor includes: a motor; and the above frequency converter. The frequency converter is adapted to drive the motor.

With the compressor according to the embodiments of the invention, the above frequency converter is adopted, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

To achieve the above objectives, according to embodiments in a seventh aspect of the invention, a vehicle is provided. The vehicle includes the above compressor.

With the vehicle according to the embodiments of the invention, the above compressor is adopted, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

Additional aspects and advantages of the invention will be provided at least in part in the following description, or will become apparent at least in part from the following description, or can be learned from practicing of the invention.


**BRIEF DESCRIPTION OF THE DRAWINGS**


FIG. 1 is a schematic structural diagram of a current sampling circuit of a frequency converter according to an embodiment of the invention.

FIG. 2 is a circuit diagram of a current sampling circuit according to an embodiment of the invention.

FIG. 3 is a flowchart illustrating switching a sampling method based on a rotational speed of a motor according to an embodiment of the invention.

FIG. 4 is a schematic sector diagram according to an embodiment of the invention.

FIG. 5 is a waveform diagram of drive signals in a first sector according to an embodiment of the invention.

FIG. 6 is a waveform diagram of drive signals in a fourth sector according to an embodiment of the invention.

FIG. 7 is a flowchart illustrating switching a sampling method based on a modulation ratio of a motor according to an embodiment of the invention.

FIG. 8 is a flowchart illustrating a three-phase current sampling method for a motor according to an embodiment of the invention.

FIG. 9 is a schematic system diagram of a frequency converter according to an embodiment of the invention.

FIG. 10 is a schematic structural diagram of a compressor according to an embodiment of the invention.

FIG. 11 is a schematic structural diagram of a vehicle according to an embodiment of the invention.

## DETAILED DESCRIPTION OF THE EMBODIMENTS

Embodiments of the invention will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limit, the invention.

A frequency converter and a current sampling circuit thereof, a three-phase current sampling method for a motor, a storage medium, a compressor, and a vehicle according to the embodiments of the invention are described below with reference to the accompanying drawings.

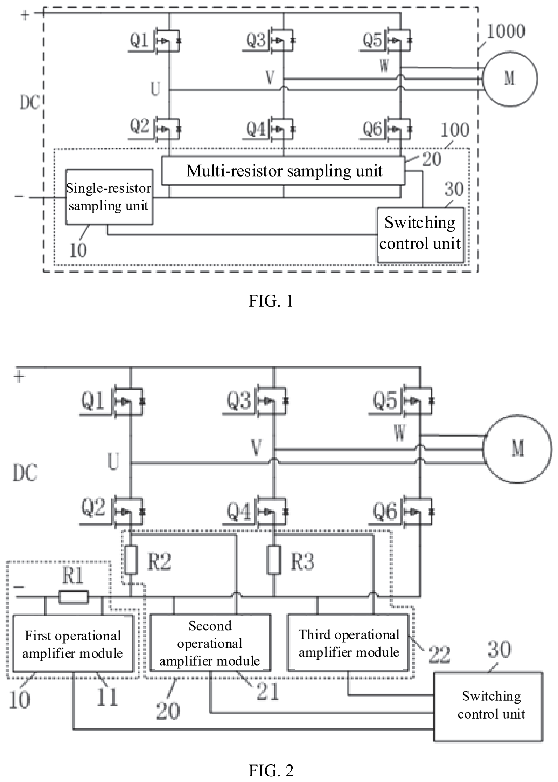

FIG. 1 is a schematic structural diagram of a current sampling circuit of a frequency converter according to an embodiment of the invention. As illustrated in FIG. 1, a frequency converter 1000 is adapted to drive a motor M in a compressor. The current sampling circuit includes a single-resistor sampling unit 10, a multi-resistor sampling unit 20, and a switching control unit 30.

The single-resistor sampling unit 10 is configured to perform current sampling at a voltage effective vector moment to obtain a three-phase current of the motor M. The multi-resistor sampling unit 20 is configured to perform current sampling at a voltage zero vector moment to obtain the three-phase current of the motor M. The switching control unit 30 is configured to acquire a parameter of the motor M, determine a switching index based on the parameter of the motor M, and select, based on the switching index, one of the single-resistor sampling unit 10 and the multi-resistor sampling unit 20 to perform current sampling.

Specifically, as illustrated in FIG. 1, the frequency converter 1000 includes six switching transistors Q1 to Q6. A U-phase bridge arm is formed by the first switching transistor Q1 and the second switching transistor Q2, a V-phase bridge arm is formed by the third switching transistor Q3 and the fourth switching transistor Q4, and a W-phase bridge arm is formed by the fifth switching transistor Q5 and the sixth switching transistor Q6, which are connected to a U-phase, a W-phase, and a V-phase of the motor M, respectively. Upper arms of a three-phase bridge are all connected to a positive terminal of a direct current bus DC. As an example, in FIG. 2, the single-resistor sampling unit 10 includes a first sampling resistor R1 disposed at the direct current bus DC. The multi-resistor sampling unit 20 includes a second sampling resistor R2 and a third sampling resistor R3. The second sampling resistor R2 is disposed at a lower arm of the U-phase. The third sampling resistor R3 is disposed at a lower arm of the V-phase. Single-resistor current sampling and multi-resistor current sampling are suitable for different application scenarios. Since parameters of the motor M vary across different application scenarios, the switching control unit 30 can determine a time for switching between current sampling methods, i.e., determine the switching index, based on the parameter of the motor M, determine an appropriate current sampling method for the motor M based on the switching index and a current parameter of the motor M, and switch to the corresponding sampling unit to perform current sampling.

It should be noted that, in this embodiment, a method for connecting the second sampling resistor R2 and the third sampling resistor R3 in the multi-resistor sampling unit 20 is not limited to a connection method illustrated in FIG. 2. The second sampling resistor R2 and the third sampling resistor R3 may be disposed at lower arms of any two phases. The multi-resistor sampling unit 20 is not limited to having only two sampling resistors. Instead, the multi-resistor sampling unit 20 may include three sampling resistors, each disposed at the lower arm of one phase. The multi-resistor sampling unit 20 illustrated in FIG. 2 is exemplary and shall not be construed as limiting the invention.

In an optional embodiment, as illustrated in FIG. 2, the single-resistor sampling unit 10 further includes a first operational amplifier module 11. The first operational amplifier module 11 is set across two terminals of the first sampling resistor R1 to obtain a first voltage sampling value through sampling a voltage across the two terminals of the first sampling resistor R1, amplify the first voltage sampling value, and input the amplified first voltage sampling value to the switching control unit 30. The multi-resistor sampling unit 20 further includes a second operational amplifier module 21 and a third operational amplifier module 22. The second operational amplifier module 21 is set across two terminals of the second sampling resistor R2 to obtain a second voltage sampling value through sampling a voltage across the two terminals of the second sampling resistor R2, amplify the second voltage sampling value, and input the amplified second voltage sampling value to the switching control unit 30. The third operational amplifier module 22 is set across two terminals of the third sampling resistor R3 to obtain a third voltage sampling value through sampling a voltage across the two terminals of the third sampling resistor R3, amplify the third voltage sampling value, and input the amplified third voltage sampling value to the switching control unit 30.

In the above embodiments, since the single-resistor current sampling and the multi-resistor current sampling are suitable for different application scenarios, the switching control unit can determine the appropriate current sampling method for the motor based on the parameter of the motor and switch to the corresponding sampling unit to perform the current sampling, which solves problems associated with the single-resistor current sampling and the multi-resistor current sampling under different application scenarios. As a result, a speed adjustment range of the motor is extended, improving performance of the motor.

In some embodiments, the parameter of the motor M includes a voltage operation range and a maximum torque of the motor M. The switching control unit 30 is further configured to determine a switching rotational speed based on the voltage operation range and the maximum torque.

It should be understood that, since the multi-resistor current sampling is suitable for application scenarios where the motor operates at a low rotational speed and the single-resistor current sampling is suitable for application scenarios where the motor operates at a high rotational speed, a time for switching between current sampling methods can be determined based on the rotational speed of the motor. The switching control unit 30 is configured to acquire the voltage operation range and the maximum torque of the motor M, determine the switching rotational speed based on the voltage operation range and the maximum torque, and switch between the current sampling methods in response to the rotational speed of the motor reaching the switching rotational speed.

In some embodiments, the switching control unit 30 is further configured to: determine, in response that the motor M operates at a lower limit of the voltage operation range and the maximum torque, a maximum rotational speed at which the motor M does not enter field-weakening control; and determine the switching rotational speed based on the maximum rotational speed.

Specifically, the motor M is controlled to operate at the lower limit of the voltage operation range and at the maximum torque. As the rotational speed of the motor M increases, in response to that the rotational speed reaches a predetermined value, the rotational speed cannot continue to increase due to the constant operation voltage and the constant maximum rotational speed of the motor M. In this case, a magnetic field of the motor M needs to be weakened to reduce a back electromotive force, in such a manner that the rotational speed is increased. The rotational speed of the motor M is sampled without weakening the magnetic field of the motor M. The sampled rotational speed of the motor M is the maximum rotational speed. Since a predetermined margin needs to be reserved for the switching rotational speed, the switching rotational speed is a product of the maximum rotational speed and a predetermined proportional coefficient. The predetermined proportional coefficient ranges from 0.3 to 0.9.

For example, hypothetically, the voltage operation range ranges from 200 V to 490 V, and the maximum torque is 7 N·m. The motor M is controlled to operate at 200 V and 7 N·m. The rotational speed of the motor M at which the motor M does not enter field weakening is sampled. The maximum rotational speed is determined to be 4,600 rpm. Since the predetermined proportional coefficient ranges from 0.3 to 0.9, the switching rotational speed ranges from 1,380 rpm to 4,140 rpm. Therefore, 4,100 rpm may be selected as the switching rotational speed.

It should be noted that, since dual-resistor sampling is suitable for low-rotational-speed applications and single-resistor sampling is suitable for high-rotational-speed applications, the switching rotational speed should be as high as possible. As the switching rotational speed increases, accuracy of the current sampling increases, and performance of the motor M is elevated. Ideally, the switching rotational speed should be: the maximum rotational speed*0.9.

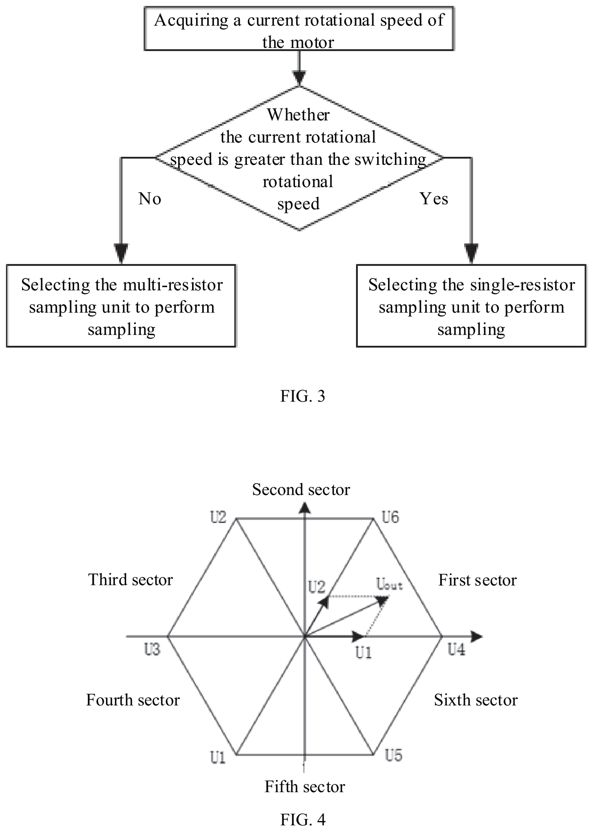

In some embodiments, as illustrated in FIG. 3, the switching control unit 30 is further configured to acquire a current rotational speed of the motor M; and in response that the current rotational speed is greater than the switching rotational speed, select the single-resistor sampling unit 10 to perform current sampling, or in response that the current rotational speed is smaller than or equal to the switching rotational speed, select the multi-resistor sampling unit 20 to perform current sampling.

Specifically, since the multi-resistor current sampling is performed at the voltage zero vector moment, a predetermined amount of time needs to be reserved for the voltage zero vector moment. Therefore, the multi-resistor current sampling is suitable for application scenarios where the motor operates at a low rotational speed. Since the single-resistor current sampling is performed at the voltage effective vector moment, the single-resistor current sampling is suitable for application scenarios where the motor operates at a high rotational speed. Therefore, in response that the current rotational speed is greater than the switching rotational speed, the current rotational speed is relatively high, and a duration during which a voltage space vector is an effective vector is relatively long, in which case the single-resistor sampling unit 10 is selected for current sampling. In response that the current rotational speed is smaller than or equal to the switching rotational speed, the current rotational speed is relatively low, and a duration during which the voltage space vector is a zero vector is relatively long, in which case the multi-resistor sampling unit 20 is selected for current sampling.

In some embodiments, the parameter of the motor M includes a modulation period and a minimum current sampling time length of the motor M. The switching control unit 30 is further configured to determine a switching modulation ratio based on the modulation period and the minimum current sampling time length.

It should be understood that the modulation ratio refers to a duty cycle of drive signals for the six switching transistors and that are generated using Space Vector Pulse Width Modulation (SVPWM). Since the multi-resistor current sampling is performed at the voltage zero vector moment, the multi-resistor current sampling is suitable for application scenarios with a relatively low modulation ratio. Since the single-resistor current sampling is performed at the voltage effective vector moment, the single-resistor current sampling is suitable for application scenarios with a relatively high modulation ratio. Therefore, the time for switching between the current sampling methods can be determined based on the modulation ratio. The switching control unit 30 is configured to determine the switching modulation ratio based on the modulation period and the minimum current sampling time length, and switch between the current sampling methods in response to the modulation ratio of the motor reaching the switching modulation ratio.

In some embodiments, the switching control unit 30 is further configured to: calculate a difference between the modulation period and four times the minimum current sampling time length; divide the difference by the modulation period to obtain a maximum modulation ratio; and determine the switching modulation ratio based on the maximum modulation ratio.

Specifically, the maximum modulation ratio is calculated in accordance with the following equation (1):

$$M \max = \frac{T - 4T \min}{T} \tag{1}.$$

In the equation (1), Mmax represents the maximum modulation ratio, T represents the modulation period, and Tmin represents the minimum current sampling time length.

Since a predetermined margin needs to be reserved for the switching modulation ratio, the switching modulation ratio is a product of the maximum modulation ratio Mmax and a predetermined proportion coefficient. The predetermined proportion coefficient ranges from 0.3 to 0.9.

A derivation process of the equation (1) is as follows.

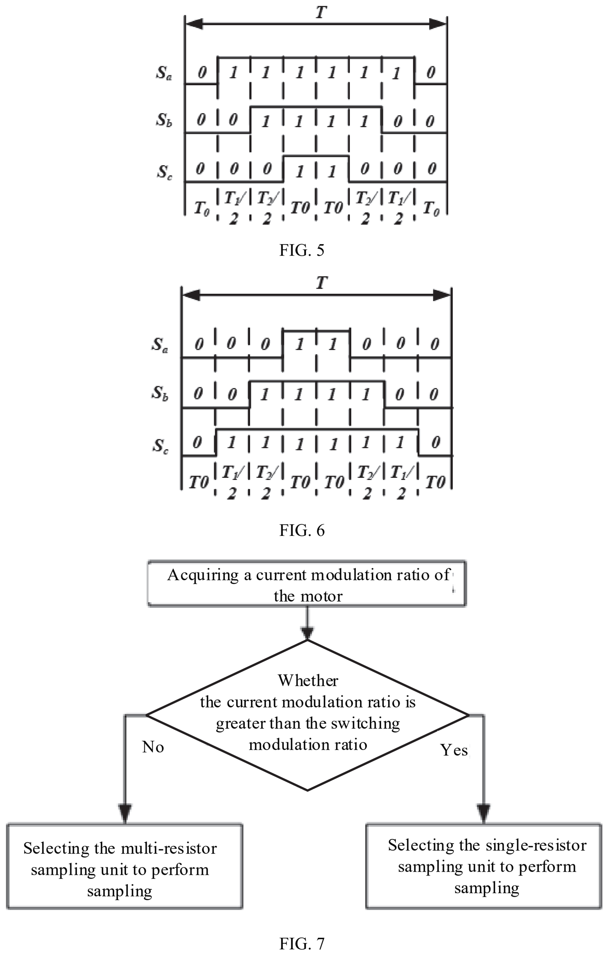

As an example, in FIG. 4, the motor M is in a first sector. FIG. 5 is a waveform diagram of driving signals corresponding to the first sector obtained based on a seven-segment SVPWM algorithm. A seven-segment voltage space vector includes three segments of zero voltage space vectors and four segments of basic voltage space vectors. A sequence of action of the seven-segment voltage space vector is sequentially (0,0,0), (1,0,0), (1,1,0), (1,1,1), (1,1,0), (1,0,0), (0,0,0), and thus the three segments of zero voltage space vectors are located at a beginning, a middle, and an end of a drive signal waveform, respectively. As illustrated in FIG. 5, the first switching transistor Q1 transitions from off to on at T0 moment, the third switching transistor Q3 transitions from off to on at T0+T1/2 moment, and the fifth switching transistor Q5 transitions from off to on at T0+T1/2+T2/2 moment, where T=T1+T2+4T0. Therefore, the first switching transistor Q1 has the largest modulation ratio. The modulation ratio of the first switching transistor Q1 is calculated in accordance with the following equation (2):

$$M = \frac{T1/2 + T2/2 + T1/2 + T2/2}{T} = \frac{T1 + T2}{T} \tag{2}.$$

When the multi-resistor sampling unit 20 is adopted for the current sampling, as illustrated in the equation (3), a duration T0 of the zero voltage space vector should be greater than the minimum current sampling time length Tmin:

$$T0 = \frac{T - (T1 + T2)}{4} > T \min \tag{3}.$$

Substituting the equation (2) into the equation (3) yields an equation (4):

$$M < \frac{T - 4T\min}{T}$$

(4).

The equation (1) for the maximum modulation ratio can be obtained based on the equation (4).

A calculation method for the modulation ratio in other sectors is the same as that for the first sector. As an example, in FIG. 6, in response that the motor M is in the fourth sector, the fifth switching transistor Q5 has the largest modulation ratio. The modulation ratio of the fifth switching transistor Q5 is also calculated in accordance with the equation (2). Therefore, using the equation (1) to calculate the maximum modulation ratio applies to all sectors.

For example, assuming that the motor M has a switching frequency of 16 kHz, a control period T=1/16 kHz=62.5 us, and the minimum current sampling time length Tmin is 3 us (including a current oscillation time length and a sampling time length). By substituting the control period T=62.5 us and the minimum current sampling time length of 3 us into the equation (1), the maximum modulation ratio Mmax=0.808 can be calculated. Considering that a predetermined margin needs to be reserved, the switching modulation ratio is 0.7.

It should be noted that, the motor according to this embodiment is not limited to adopting the seven-segment SVPWM algorithm, and may also adopt a five-segment SVPWM algorithm. However, in response that the five-segment SVPWM algorithm is adopted, it is necessary to distinguish between two cases: one in which an upper bridge arm of one phase is always 0, and the other in which the upper bridge arm of one phase is always 1. Calculation methods for the maximum modulation ratio in the two cases are different. Therefore, in response that the five-segment SVPWM algorithm is adopted, the calculation of the maximum modulation ratio is relatively complex.

In some embodiments, as illustrated in FIG. 7, the switching control unit 30 is further configured to: acquire a current modulation ratio of the motor M; and in response that the current modulation ratio is greater than the switching modulation ratio, select the single-resistor sampling unit 10 to perform current sampling, or in response that the current modulation ratio is smaller than or equal to the switching modulation ratio, select the multi-resistor sampling unit 20 to perform current sampling.

Specifically, since the multi-resistor current sampling is performed at the voltage zero vector moment, a predetermined amount of time needs to be reserved for the zero voltage vector moment. Therefore, the multi-resistor current sampling is suitable for application scenarios where the modulation ratio is low. Since the single-resistor current sampling is performed at the voltage effective vector moment, the single-resistor current sampling is suitable for application scenarios where the modulation ratio is high. The modulation ratios of bridge arms of individual phases are obtained. A highest modulation ratio among the modulation ratios is determined as the current modulation ratio. Therefore, in response that the current modulation ratio is greater than the switching modulation ratio, the current modulation ratio is relatively high, and a duration during which a voltage space vector is an effective vector is relatively long, in which case the single-resistor sampling unit 10 is selected for current sampling. In response that the current modulation ratio is smaller than or equal to the switching modulation ratio, the current modulation ratio is relatively low, and a duration during which the voltage space vector is a zero vector is relatively long, in which case the multi-resistor sampling unit 20 is selected for current sampling.

In summary, the current sampling circuit of the frequency converter according to the embodiments of the invention includes the single-resistor sampling unit, the multi-resistor sampling unit, and the switching control unit. The switching control unit is configured to acquire the parameter of the motor, determine the switching index based on the parameter of the motor, and select, based on the switching index, one of the single-resistor sampling unit and the multi-resistor sampling unit to perform current sampling. In this way, the switching control unit is capable of switching between single-resistor sampling and multi-resistor sampling based on the parameter of the motor and respective application scenarios of the single-resistor sampling and the multi-resistor sampling, which solves the problems of loud motor noises caused by using only single-resistor sampling and degraded motor performance caused by using only multi-resistor sampling. As a result, a speed adjustment range of the motor is extended, improving the performance of the motor.

Corresponding to the above embodiments, the embodiments of the invention further provide a frequency converter. As illustrated in FIG. 1, the frequency converter 1000 includes the current sampling circuit 100 according to any of the above embodiments.

With the frequency converter according to the embodiments of the invention, the above current sampling circuit is adopted, and switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

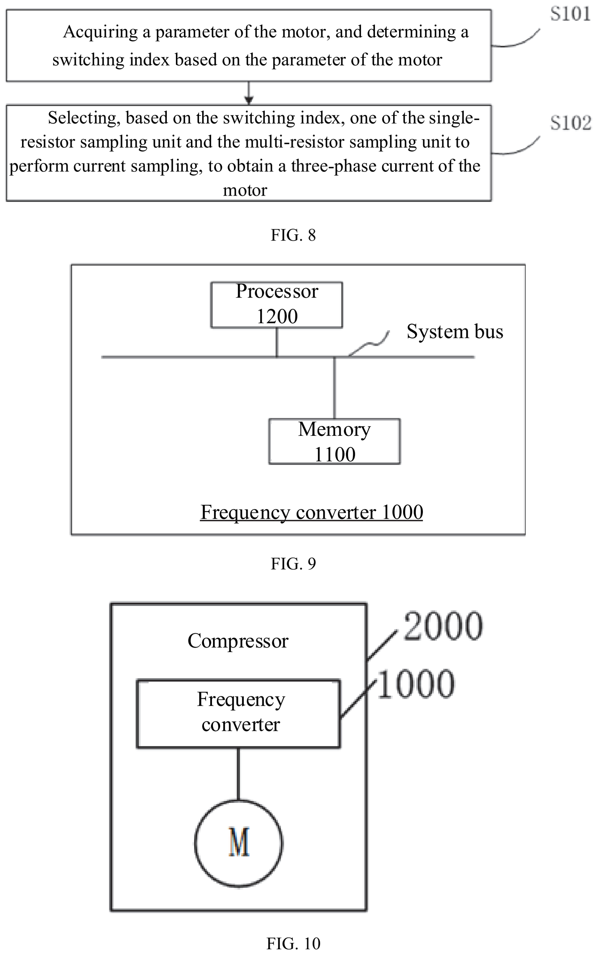

Corresponding to the above embodiments, the embodiments of the invention further provide a three-phase current sampling method for the motor. The motor M is disposed in the compressor. The three-phase current sampling method for the motor is applied in the frequency converter 1000 as illustrated in FIG. 1. The frequency converter 1000 is adapted to drive the motor M and includes the single-resistor sampling unit 10 and the multi-resistor sampling unit 20. As illustrated in FIG. 8, the three-phase current sampling method for the motor includes operations at blocks.

At S101, a parameter of the motor is acquired, and a switching index is determined based on the parameter of the motor.

Specifically, the single-resistor current sampling and the multi-resistor current sampling are suitable for different application scenarios. Since the parameters of the motor vary across different application scenarios, the time for switching between the current sampling methods, i.e., the switching index, can be determined based on the parameter of the motor.

At S102, one of the single-resistor sampling unit and the multi-resistor sampling unit is selected based on the switching index to perform current sampling, to obtain a three-phase current of the motor.

Specifically, the appropriate current sampling method for the motor is determined based on the switching index and the current parameter of the motor. The corresponding sampling unit is selected to perform the current sampling.

In a case where the single-resistor current sampling is adopted, a first current value sampled by the single-resistor sampling unit is acquired in response that the voltage space vector is a first active vector, and a second current value sampled by the single-resistor sampling unit is acquired in response that the voltage space vector is a second active vector. A current phase sampled in response that the voltage space vector is the first active vector differs from that in response that the voltage space vector is the second active vector. Since a sum of three-phase currents equals zero, a third current value can be calculated based on the first current value and the second current value, thereby obtaining the three-phase currents of the motor.

In a case where the dual-resistor current sampling illustrated in FIG. 2 is adopted, the first current value and the second current value that are sampled by the dual-resistor sampling unit are acquired in response that the voltage space vector is a zero vector. Since the sum of the three-phase currents equals zero, the third current value can be calculated based on the first current value and the second current value, thereby obtaining the three-phase currents of the motor.

It should be noted that, in this embodiment, the method for connecting the second sampling resistor R2 and the third sampling resistor R3 in the multi-resistor sampling unit 20 is not limited to the connection method illustrated in FIG. 2. The second sampling resistor R2 and the third sampling resistor R3 may be disposed at lower arms of any two phases. The multi-resistor sampling unit 20 is not limited to having only two sampling resistors. Instead, the multi-resistor sampling unit 20 may include three sampling resistors, each disposed at the lower arm of one phase. The multi-resistor sampling unit illustrated in FIG. 2 is exemplary and shall not be construed as limiting the invention.

In the above embodiments, since the single-resistor current sampling and the multi-resistor current sampling are suitable for different application scenarios, the switching control unit can determine the appropriate current sampling method for the motor based on the parameter of the motor and switch to the corresponding sampling unit to perform the current sampling, which solves problems associated with the single-resistor current sampling and the multi-resistor current sampling under different application scenarios. As a result, the speed adjustment range of the motor is extended, improving the performance of the motor.

In some embodiments, the parameter of the motor includes a voltage operation range and a maximum torque of the motor. The operation of determining the switching index based on the parameter of the motor includes: determining, in response that the motor operates at a lower limit of the voltage operation range and the maximum torque, a maximum rotational speed at which the motor does not enter field-weakening control; and determining a switching rotational speed based on the maximum rotational speed.

Specifically, the motor is controlled to operate at the lower limit of the voltage operation range and at the maximum torque. As the rotational speed of the motor increases, in response to that the rotational speed reaches the predetermined value, the rotational speed cannot continue to increase due to the constant operation voltage and the constant maximum rotational speed of the motor. In this case, the magnetic field of the motor needs to be weakened to reduce the back electromotive force, in such a manner that the rotational speed is increased. The rotational speed of the motor is sampled without weakening the magnetic field of the motor. The sampled rotational speed of the motor is the maximum rotational speed. Since the predetermined margin needs to be reserved for the switching rotational speed, the switching rotational speed is the product of the maximum rotational speed and the predetermined proportional coefficient. The predetermined proportional coefficient ranges from 0.3 to 0.9.

For example, hypothetically, the voltage operation range ranges from 200 V to 490 V, and the maximum torque is 7 N·m. The motor is controlled to operate at 200 V and 7 N·m. The rotational speed of the motor at which the motor does not enter field weakening is sampled. The maximum rotational speed is determined to be 4,600 rpm. Since the predetermined proportional coefficient ranges from 0.3 to 0.9, the switching rotational speed ranges from 1,380 rpm to 4,140 rpm. Therefore, 4,100 rpm may be selected as the switching rotational speed.

It should be noted that, since the dual-resistor sampling is suitable for low-rotational-speed applications and the single-resistor sampling is suitable for high-rotational-speed applications, the switching rotational speed should be as high as possible. As the switching rotational speed increases, the accuracy of the current sampling increases, and the performance of the motor is elevated. Ideally, the switching rotational speed should be: the maximum rotational speed*0.9.

In some embodiments, the operation of selecting, based on the switching index, one of the single-resistor sampling unit and the multi-resistor sampling unit to perform current sampling includes: acquiring a current rotational speed of the motor; and in response that the current rotational speed is greater than the switching rotational speed, selecting the single-resistor sampling unit to perform current sampling, or in response that the current rotational speed is smaller than or equal to the switching rotational speed, selecting the multi-resistor sampling unit to perform current sampling.

Specifically, since the multi-resistor current sampling is performed at the voltage zero vector moment, a predetermined amount of time needs to be reserved for the voltage zero vector moment. Therefore, the multi-resistor current sampling is suitable for application scenarios where the motor operates at a low rotational speed. Since the single-resistor current sampling is performed at the voltage effective vector moment, the single-resistor current sampling is suitable for application scenarios where the motor operates at a high rotational speed. Therefore, in response that the current rotational speed is greater than the switching rotational speed, the current rotational speed is relatively high, and a duration during which a voltage space vector is an effective vector is relatively long, in which case the single-resistor sampling unit is selected for current sampling. In response that the current rotational speed is smaller than or equal to the switching rotational speed, the current rotational speed is relatively low, and a duration during which the voltage space vector is a zero vector is relatively long, in which case the multi-resistor sampling unit is selected for current sampling.

In some embodiments, the parameter of the motor includes a modulation period and a minimum current sampling time length of the motor. The operation of determining the switching index based on the parameter of the motor includes: calculating a difference between the modulation period and four times the minimum current sampling time length; dividing the difference by the modulation period to obtain a maximum modulation ratio; and determining a switching modulation ratio based on the maximum modulation ratio.

Specifically, the maximum modulation ratio is calculated in accordance with the equation (1). Since the predetermined margin needs to be reserved for the switching modulation ratio, the switching modulation ratio is the product of the maximum modulation ratio Mmax and the predetermined proportion coefficient. The predetermined proportion coefficient ranges from 0.3 to 0.9.

For example, assuming that the motor has a switching frequency of 16 kHz, the control period T=1/16 kHz=62.5 us, and the minimum current sampling time length is 3 us (including the current oscillation time length and the sampling time length). By substituting the control period T=62.5 us and the minimum current sampling time length of 3 us into the equation (1), the maximum modulation ratio Mmax=0.808 can be calculated. Considering that the predetermined margin needs to be reserved, the switching modulation ratio is 0.7.

It should be noted that, the motor according to this embodiment is not limited to adopting the seven-segment SVPWM algorithm, and may also adopt the five-segment SVPWM algorithm. However, in response that the five-segment SVPWM algorithm is adopted, it is necessary to distinguish between two cases: one in which the upper bridge arm of one phase is always 0, and the other in which the upper bridge arm of one phase is always 1. Calculation methods for the maximum modulation ratio in the two cases are different. Therefore, in response that the five-segment SVPWM algorithm is adopted, the calculation of the maximum modulation ratio is relatively complex.

In some embodiments, the operation of selecting, based on the switching index, one of the single-resistor sampling unit and the multi-resistor sampling unit to perform current sampling includes: acquiring a current modulation ratio of the motor; and in response that the current modulation ratio is greater than the switching modulation ratio, selecting the single-resistor sampling unit to perform current sampling, or in response that the current modulation ratio is smaller than or equal to the switching modulation ratio, selecting the multi-resistor sampling unit to perform current sampling.

Specifically, since the multi-resistor current sampling is performed at the voltage zero vector moment, the predetermined amount of time needs to be reserved for the voltage zero vector moment. Therefore, the multi-resistor current sampling is suitable for application scenarios where the modulation ratio is low. Since the single-resistor current sampling is performed at the voltage effective vector moment, the single-resistor current sampling is suitable for application scenarios where the modulation ratio is high. The modulation ratios of bridge arms of individual phases are acquired. The highest modulation ratio among the modulation ratios is determined as the current modulation ratio. Therefore, in response that the current modulation ratio is greater than the switching modulation ratio, the current modulation ratio is relatively high, and a duration during which a voltage space vector is an effective vector is relatively long, in which case the single-resistor sampling unit is selected for current sampling. In response that the current modulation ratio is smaller than or equal to the switching modulation ratio, the current modulation ratio is relatively low, and a duration during which the voltage space vector is a zero vector is relatively long, in which case the multi-resistor sampling unit is selected for current sampling.

In summary, with the three-phase current sampling method for the motor according to the embodiments of the invention, the parameter of the motor is acquired, the switching index is determined based on the parameter of the motor, and one of the single-resistor sampling unit and the multi-resistor sampling unit is selected based on the switching index to perform current sampling. The frequency converter includes the single-resistor sampling unit, the multi-resistor sampling unit, and the switching control unit. In this way, switching is performed between the single-resistor sampling and the multi-resistor sampling based on the parameter of the motor and respective application scenarios of the single-resistor sampling and the multi-resistor sampling, which solves the problems of loud motor noises caused by using only single-resistor sampling and degraded motor performance caused by using only multi-resistor sampling. As a result, the speed adjustment range of the motor is extended, improving the performance of the motor.

Corresponding to the above embodiments, the embodiments of the invention further provide a computer-readable storage medium. The computer-readable storage medium stores a three-phase current sampling program for a motor. The three-phase current sampling program, in response to being executed by a processor, implements the three-phase current sampling method for the motor according to any of the above embodiments.

With the computer-readable storage medium according to the embodiments of the invention, the above three-phase current sampling method for the motor is performed by the three-phase current sampling program, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

Corresponding to the above embodiments, the embodiments of the invention further provide another frequency converter. As illustrated in FIG. 9, the frequency converter 1000 includes: a memory 1100; a processor 1200; and a three-phase current sampling program for a motor stored on the memory 1100 and executable on the processor 1200. The processor 1200, in response to executing the three-phase current sampling program, implements the three-phase current sampling method for the motor according to any of the above embodiments.

With the frequency converter according to the embodiments of the invention, the three-phase current sampling program implementing the above three-phase current sampling method for the motor is executed by the processor, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

Corresponding to the above embodiments, the embodiments of the invention further provide a compressor. As illustrated in FIG. 10, a compressor 2000 includes: the motor M; and the above frequency converter 1000. The frequency converter 1000 is adapted to drive the motor M.

With the compressor according to the embodiments of the invention, the above frequency converter is adopted, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

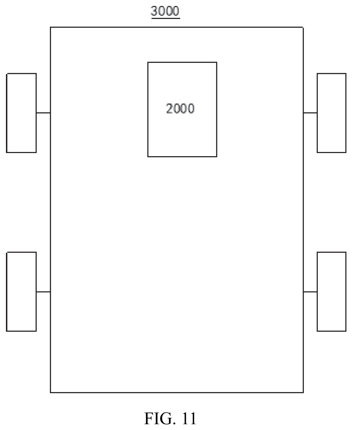

Corresponding to the above embodiments, the embodiments of the invention further provide a vehicle. As illustrated in FIG. 11, a vehicle 3000 includes the compressor 2000.

According to the embodiments of the invention, the vehicle includes the compressor according to any of the above embodiments. The vehicle may be a new energy vehicle. In some embodiments, the new energy vehicle may be a purely electric vehicle that uses a motor as a main driving force. In other embodiments, the new energy vehicle may be a hybrid electric vehicle that uses both an internal combustion engine and a motor as main driving forces. Regarding the internal combustion engine and the motor mentioned in the above embodiments that provide the driving forces for the new energy vehicle, the internal combustion engine may use gasoline, diesel, hydrogen, or the like as fuels, while the motor may be powered by a traction battery, a hydrogen fuel battery, etc. The invention is not limited to any of these examples. It should be noted that, only an exemplary description of a structure such as the new energy vehicle is made here, which is not intended to limit the scope of the invention.

With the vehicle according to the embodiments of the invention, the above frequency converter is adopted, and the switching is performed between the single-resistor sampling and the multi-resistor sampling based on the parameter of the motor, which can solve the problems of loud motor noises caused by using only single-resistor sampling and degraded motor performance caused by using only multi-resistor sampling. As a result, the performance of the motor is improved.

It should be noted that, the logics and/or steps represented in the flowchart or described otherwise herein can be for example considered as a list of ordered executable instructions for implementing logic functions, and can be embodied in any computer-readable medium that is to be used by or used with an instruction execution system, apparatus, or device (such as a computer-based system, a system including a processor, or any other system that can retrieve and execute instructions from an instruction execution system, apparatus, or device). For this description, a "computer-readable medium" can be any apparatus that can contain, store, communicate, propagate, or transmit a program to be used by or used with an instruction execution system, apparatus, or device. More specific examples of computer-readable mediums include, as a non-exhaustive list: an electrical connector (electronic device) with one or more wirings, a portable computer disk case (magnetic devices), a Random Access Memory (RAM), a Read Only Memory (ROM), an Erasable Programmable Read Only Memory (EPROM or flash memory), a fiber optic device, and a portable Compact Disk Read Only memory (CDROM). In addition, the computer-readable medium may even be paper or other suitable medium on which the program can be printed, as the program can be obtained electronically, e.g., by optically scanning the paper or the other medium, and then editing, interpreting, or otherwise processing the scanning result when necessary, and then stored in a computer memory.

It should be understood that each part of the invention may be realized by hardware, software, firmware, or a combination thereof. In the above embodiments, several steps or methods may be realized by software or firmware stored in the memory and executed by an appropriate instruction execution system. For example, when it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a Programmable Gate Array (PGA), a Field Programmable Gate Array (FPGA), etc.

Reference throughout this specification to "an embodiment", "some embodiments", "an example", "a specific example", or "some examples" means that a particular feature, structure, material, or characteristic described in connection with the embodiment or example is included in at least one embodiment or example of the invention. The appearances of the above phrases in various places throughout this specification are not necessarily referring to the same embodiment or example. Further, the particular features, structures, materials, or characteristics may be combined in any suitable manner in one or more embodiments or examples.

In addition, terms such as "first" and "second" in the embodiments of the invention are only used for descriptive purposes, and cannot be understood as indicating or implying relative importance or implicitly indicating the number of indicated technical features in the embodiments. Therefore, the features associated with the terms such as "first" and "second" in the embodiments of the invention may explicitly or implicitly include at least one of the features in the embodiments. In the description of the invention, "plurality" means at least two or two or more, unless otherwise specifically defined.

In the invention, unless otherwise clearly specified or limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components. For those skilled in the art, the specific meaning of the above-mentioned terms in the invention can be understood according to specific circumstances.

Although embodiments of the invention have been shown and described above, it should be understood that the above embodiments are merely exemplary, and cannot be construed to limit the invention. For those skilled in the art, changes, alternatives, and modifications can be made to the embodiments without departing from the scope of the invention.

**Claims**

1. A current sampling circuit of a frequency converter, the frequency converter being adapted to drive a motor in a compressor, the current sampling circuit comprising:

    a single-resistor sampling unit configured to perform current sampling at a voltage effective vector moment to obtain a three-phase current of the motor;
    a multi-resistor sampling unit configured to perform current sampling at a voltage zero vector moment to obtain the three-phase current of the motor; and
    a switching control unit configured to acquire a parameter of the motor, determine a switching index based on the parameter of the motor, and select, based on the switching index, one of the single-resistor sampling unit and the multi-resistor sampling unit to perform current sampling.

2. The current sampling circuit according to claim 1, wherein the parameter of the motor comprises a voltage operation range and a maximum torque of the motor, and the switching control unit is further configured to determine a switching rotational speed based on the voltage operation range and the maximum torque.

3. The current sampling circuit according to claim 2, wherein the switching control unit is further configured to: determine, in response to the motor operating at a lower limit of the voltage operation range and the maximum torque, a maximum rotational speed at which the motor does not enter field-weakening control; and determine the switching rotational speed based on the maximum rotational speed.

4. The current sampling circuit according to claim 2 or 3, wherein the switching control unit is further configured to:

acquire a current rotational speed of the motor; and

in response to the current rotational speed being greater than the switching rotational speed, select the single-resistor sampling unit to perform current sampling, or in response to the current rotational speed being smaller than or equal to the switching rotational speed, select the multi-resistor sampling unit to perform current sampling.

5. The current sampling circuit according to claim 1, wherein the parameter of the motor comprises a modulation period and a minimum current sampling time length of the motor, and the switching control unit is further configured to determine a switching modulation ratio based on the modulation period and the minimum current sampling time length.

6. The current sampling circuit according to claim 5, wherein the switching control unit is further configured to:

calculate a difference between the modulation period and four times the minimum current sampling time length;

divide the difference by the modulation period to obtain a maximum modulation ratio; and

determine the switching modulation ratio based on the maximum modulation ratio.

7. The current sampling circuit according to claim 5 or 6, wherein the switching control unit is further configured to:

acquire a current modulation ratio of the motor; and

in response to the current modulation ratio being greater than the switching modulation ratio, select the single-resistor sampling unit to perform current sampling, or in response to the current modulation ratio being smaller than or equal to the switching modulation ratio, select the multi-resistor sampling unit to perform current sampling.

8. A frequency converter, comprising the current sampling circuit according to any one of claims 1 to 7.

9. A three-phase current sampling method for a motor, the motor being disposed in a compressor, the three-phase current sampling method being applied in a frequency converter, and the frequency converter being adapted to drive the motor and comprising a single-resistor sampling unit and a multi-resistor sampling unit, wherein the three-phase current sampling method comprises:

acquiring a parameter of the motor, and determining a switching index based on the parameter of the motor; and

selecting, based on the switching index, one of the single-resistor sampling unit and the multi-resistor sampling unit to perform current sampling, to obtain a three-phase current of the motor.

10. The three-phase current sampling method according to claim 9, wherein the parameter of the motor comprises a voltage operation range and a maximum torque of the motor, and said determining the switching index based on the parameter of the motor comprises:

determining, in response to the motor operating at a lower limit of the voltage operation range and the maximum torque, a maximum rotational speed at which the motor does not enter field-weakening control; and

determining a switching rotational speed based on the maximum rotational speed.

11. The three-phase current sampling method according to claim 10, wherein said selecting, based on the switching index, one of the single-resistor sampling unit and the multi-resistor sampling unit to perform current sampling comprises:

acquiring a current rotational speed of the motor; and

in response to the current rotational speed being greater than the switching rotational speed, selecting the single-resistor sampling unit to perform current sampling, or in response to the current rotational speed being smaller than or equal to the switching rotational speed, selecting the multi-resistor sampling unit to perform current sampling.

12. The three-phase current sampling method according to claim 9, wherein the parameter of the motor comprises a modulation period and a minimum current sampling time length of the motor, and said determining the switching index based on the parameter of the motor comprises:

calculating a difference between the modulation period and four times the minimum current sampling time length;

dividing the difference by the modulation period to obtain a maximum modulation ratio; and

determining a switching modulation ratio based on the maximum modulation ratio.

13. The three-phase current sampling method according to claim 12, wherein said selecting, based on the switching index, one of the single-resistor sampling unit and the multi-resistor sampling unit to perform current sampling comprises:

acquiring a current modulation ratio of the motor; and
in response to the current modulation ratio being greater than the switching modulation ratio, selecting the single-resistor sampling unit to perform current sampling, or in response to the current modulation ratio being smaller than or equal to the switching modulation ratio, selecting the multi-resistor sampling unit to perform current sampling.

14. A computer-readable storage medium, having a three-phase current sampling program for a motor stored thereon, wherein the three-phase current sampling program, in response to being executed by a processor, implements the three-phase current sampling method for the motor according to any one of claims 9 to 13.

15. A frequency converter, comprising:

a memory;
a processor; and
a three-phase current sampling program for the motor stored on the memory and executable on the processor, wherein the processor, in response to executing the three-phase current sampling program, implements the three-phase current sampling method for the motor according to any one of claims 9 to 13.

16. A compressor, comprising:

a motor; and
the frequency converter according to claim 8 or 15, the frequency converter being adapted to drive the motor.

17. A vehicle, comprising the compressor according to claim 16.

FIG. 1

FIG. 2

Acquiring a current rotational speed of the motor

Whether the current rotational speed is greater than the switching rotational speed

No

Yes

Selecting the multi-resistor sampling unit to perform sampling

Selecting the single-resistor sampling unit to perform sampling

FIG. 3

Second sector

U2   U6

Third sector

U2   Uout

First sector

U3   U1   U4

Fourth sector

Sixth sector

U1   U5

Fifth sector

FIG. 4

FIG. 5

FIG. 6

Acquiring a current modulation ratio of the motor

Whether the current modulation ratio is greater than the switching modulation ratio

No

Yes

Selecting the multi-resistor sampling unit to perform sampling

Selecting the single-resistor sampling unit to perform sampling

FIG. 7

| Acquiring a parameter of the motor, and determining a switching index based on the parameter of the motor | S101 |

↓

| Selecting, based on the switching index, one of the single-resistor sampling unit and the multi-resistor sampling unit to perform current sampling, to obtain a three-phase current of the motor | S102 |

FIG. 8

Processor 1200

System bus

Memory 1100

Frequency converter 1000

FIG. 9

Compressor

Frequency converter

2000

1000

M

FIG. 10

3000

2000

FIG. 11

## INTERNATIONAL SEARCH REPORT

| International application No. |
| --- |
| **PCT/CN2024/111797** |

| A. | CLASSIFICATION OF SUBJECT MATTER |
| --- | --- |

H02M1/00(2007.01)i; H02P21/00(2016.01)i

According to International Patent Classification (IPC) or to both national classification and IPC

| B. | FIELDS SEARCHED |
| --- | --- |

Minimum documentation searched (classification system followed by classification symbols)

IPC: H02M, H02P

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 单电阻, 双电阻, 三电阻, 多电阻, 零, 转速, 周期, 采样时间, 转矩, 弱磁, single, resistance, double, triple, three, zero, time, torque, sample, weaken+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 112436749 A (HANGZHOU SILAN MICROELECTRONICS CO., LTD.) 02 March 2021 (2021-03-02) <br> description, paragraphs 162-292, and figures 1-8A and 9 | 1, 5, 7-9, 14-17 |
| A | WO 2022127167 A1 (FANS-TECH ELECTRIC CO., LTD.) 23 June 2022 (2022-06-23) <br> entire document | 1-17 |
| A | CN 114157175 A (FOSHAN SHUNDE MIDEA ELECTRONIC TECHNOLOGY CO., LTD. et al.) 08 March 2022 (2022-03-08) <br> entire document | 1-17 |
| A | CN 115940732 A (WELLING (WUHU) MOTOR MANUFACTURING CO., LTD.) 07 April 2023 (2023-04-07) <br> entire document | 1-17 |
| A | CN 114123872 A (GUANGDONG MEIZHI COMPRESSOR CO., LTD.) 01 March 2022 (2022-03-01) <br> entire document | 1-17 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 November 2024** | **12 November 2024** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/111797**

| Patent document cited in search report | | | Publication date (day/month/year) | Patent family member(s) | | | Publication date (day/month/year) |
|---|---|---|---|---|---|---|---|
| CN | 112436749 | A | 02 March 2021 | None | | | |
| WO | 2022127167 | A1 | 23 June 2022 | CN | 112688611 | A | 20 April 2021 |
| CN | 114157175 | A | 08 March 2022 | None | | | |
| CN | 115940732 | A | 07 April 2023 | None | | | |
| CN | 114123872 | A | 01 March 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311526796 X